Europäisches Patentamt

European Patent Office

Office européen des brevets

(11) Publication number: **0 600 091 A1**

## EUROPEAN PATENT APPLICATION
## published in accordance with Art. 158(3) EPC

(21) Application number: 93910380.0

(22) Date of filing: 24.05.93

(86) International application number: **PCT/JP93/00682**

(87) International publication number: **WO 93/24997 (09.12.93 93/29)**

(51) Int. Cl.5: **H03K 5/13, H04L 25/02**

(30) Priority: **25.05.92 JP 132608/92**

(43) Date of publication of application: **08.06.94 Bulletin 94/23**

(84) Designated Contracting States: **DE FR GB IT NL**

(71) Applicant: **JAPAN AVIATION ELECTRONICS INDUSTRY, LIMITED**
**1-21-6, Dogenzaka**
**Shibuya-ku Tokyo 150(JP)**

(72) Inventor: **KAHARU, Takeo**
**39-8, Denenchofu Honcho,**
**Ota-ku**
**Tokyo 145(JP)**

(74) Representative: **Blumbach Weser Bergen**
**Kramer Zwirner Hoffmann Patentanwälte**
**Bahnhofstrasse 103**
**D-82166 Gräfelfing (DE)**

(54) **DIGITAL SIGNAL RECEIVER.**

(57) In a digital signal receiver, an input optical signal $S_{OP}$ is converted to an electrical signal by a photodetector (14) of a receiving circuit R, is amplified by an amplifier (15) and is compared with a reference voltage by a comparator (16), which produces a signal $S_d$. This signal is supplied as a trigger signal to a re-triggerable monostable multivibrator (17) to produce a square wave signal $S_{do}$ having a predetermined width. The signal $S_d$ from the circuit R is added to the signal $S_{do}$ from the multivibrator (17), and the resulting signal $S_p$ is output from the receiver.

**FIG. 4**

## TECHNICAL FIELD

The present invention relates to an optical or electrical digital signal receiving device and, more particularly, the invention concerns reduction of the rise time of such a receiving device from the input thereto of a received signal to the generation therefrom an output signal.

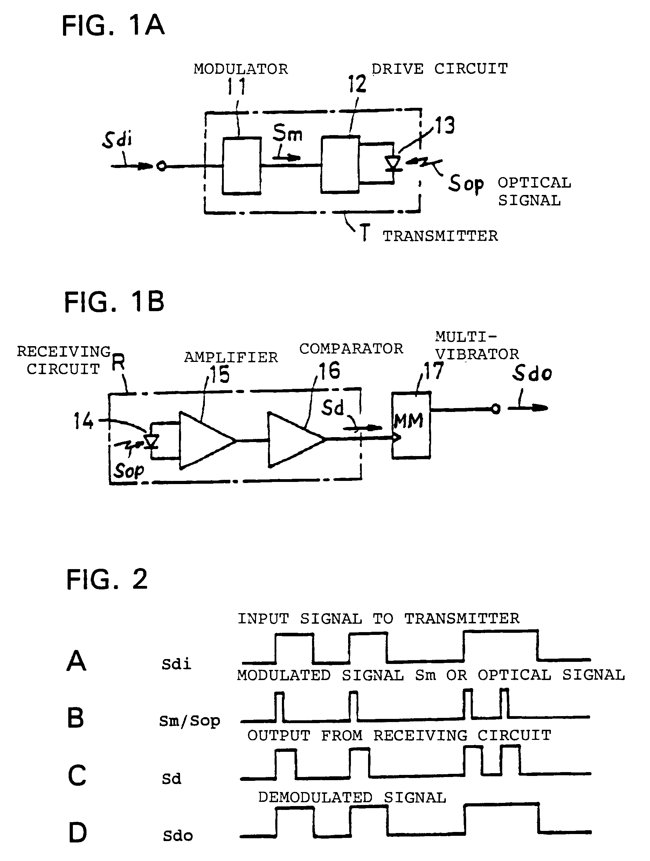

A prior art construction will be described below as being applied to optical signal transmitting and receiving devices of Figs. 1A and 1B with reference to Fig. 2 which shows signal waveforms occurring at respective parts therein. A digital signal (a Manchester code such as shown in Fig. 2-Row A) Sdi that is input into a transmitter T depicted in Fig. 1A is modulated by a modulator 11 into a pulse signal Sm (Fig. 2-Row B) that is generated at the rise of the modulator or a certain elapsed time thereafter. The output Sm is input into a drive circuit 12 and its output is applied to a light emitting element 13; the electrical signal is converted into an optical signal Sop (Fig. 2-B), which is applied to a transmitting medium. When receiving the optical signal Sop, a receiving device of Fig. 2B converts it by a photodetector 14 into an electrical signal, amplifies it by an amplifier 15, compares the amplified signal by a comparator 16 with a reference voltage, thus regenerating a digital signal Sd (Fig. 2-Row C). However, this output digital signal is a mere timing signal; hence, to regenerate the digital signal (a Manchester code) Sd input into the transmitter T, the digital signal Sd is usually input as a trigger signal to a retriggerable monostable multivibrator (LS123 or the like) 17 to obtain therefrom a pulse signal Sdo of a predetermined width (Fig. 2-Row D).

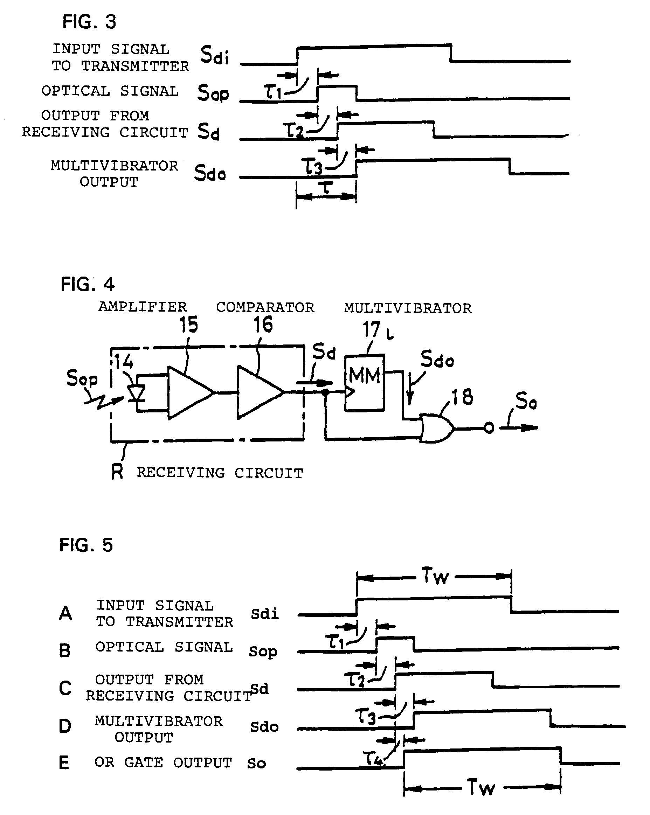

In Fig. 3 there are shown the above-described transmitting and receiving processes as a timing chart of signals at respective stages, including time lags in respective circuit blocks. In Fig. 3, letting a delay in the rise for converting the input signal Sdi to the optical signal Sop be represented by $\tau_1$, a delay from the input into the photodetector 14 to the generation of the output Sd from the comparator 16 by $\tau_2$ and a delay from the generation of the comparator output Sd to the generation of the output Sdo from the multivibrator 17 by $\tau_3$, a total delay time $\tau$ for the modulating and demodulating operations, excepting a delay in the transmission line, is $\tau = \tau_1 + \tau_2 + \tau_3$.

Thus, when the conventional receiving device is used, the delay time throughout transmission and reception is $\tau = \tau_1 + \tau_2 + \tau_3$, and this delay time $\tau$ must be reduced for an application which imposes a severe limitation on the delay time $\tau$ throughout transmission and reception.

An object of the present invention is to reduce the delay time of the signal receiving device.

## DISCLOSURE OF THE INVENTION

According to the present invention, an OR gate is added to the conventional receiving device to carry out the logical OR between the outputs from the receiving circuit and the monostable multivibrator, and the output from the OR gate is used as the output from the receiving device. Since the OR gate usually rises faster than the monostable multivibrator, the rise time of the receiving device decreases accordingly.

## BRIEF DESCRIPTION OF THE DRAWINGS

Fig. 1A is a block diagram of a conventional transmitter.

Fig. 1B is a block diagram of a conventional receiving device.

Fig. 2 is a waveform diagram showing signals occurring at principal parts in Figs. 1A and 1B.

Fig. 3 is a timing chart showing signals at respective parts in Figs. 1A and 1B.

Fig. 4 is a block diagram of a receiving device according to the present invention.

Fig. 5 is a timing chart showing signals occurring at respective parts in Figs. 1A and 4.

## BEST MODE FOR CARRYING OUT THE INVENTION

Fig. 4 is a circuit block diagram of an embodiment of the digital signal receiving device according to the present invention and Fig. 5-Rows A through E are timing charts of signals occurring at respective parts. The device of this example is an optical signal receiving device, which is assumed to receive the optical signal Sop from the transmitter T shown in Fig. 1A. The receiving circuit R is also identical in construction with that depicted in Fig. 1A.

A pulse signal of a pulse width Tw (a Manchester code or the like) shown in Fig. 5-Row A is input as the input signal Sdi into the transmitter T in Fig. 1A and is converted by the modulator 11 into a timing signal of a smaller width. The timing signal is converted by the light emitting element 13 into an optical signal Sop (Fig. 5-Row B), which is applied to the transmitting medium. Let a delay in the generation of the optical signal Sop after the input of the input signal Sdi be represented by $\tau_1$. The optical signal Sop is applied to the photodetector 14 in the receiving device of Fig. 4 and the output from the photoconductor 14 is applied via the amplifier 15 to the comparator 16, from which a binary digital signal Sd is provided as an output of the receiving circuit R. Let a delay in the generation of the receiver output Sd after the input of the optical signal Sop, excepting a delay by the transmission line, be represented by $\tau_2$.

According to the present invention, the receiver output Sd is applied to a trigger input terminal of the monostable multivibrator 17 and a last-stage OR gate 18. In the OR gate 18 the receiver output Sd and the multivibrator output Sdo (Fig. 5-Row D) are added to obtain an ultimate output signal So (Fig. 5-Row E). Hence, the rise of the output signal S is determined by an earlier one of the two input signals Sd and Sdo into the OR gate 18 and the delay by the gate is such as indicated by $\tau_4$. Since the delay $\tau_4$ by the OR gate is usually smaller than the delay $\tau_3$ by the monostable multivibrator 17, the delay time throughout transmission and reception is $\tau = \tau_1 + \tau_2 + \tau_4$, which is shorter by $\tau_3 - \tau_4$ than in the prior art.

For instance, when an analog one-shot multivibrator LS123 is used as the multivibrator 17, its rise time is 23 to 44 nsec. On the other hand, when a fast OR gate HD74AC32 is used as the OR gate 18, its rise time is 5.5 to 8.5 nsec; hence, the delay can be reduced by 14.5 to 38.5 nsec as compared with that in the prior art.

While in the above the present invention has been described in connection with the case where the transmission signal over the transmitting medium is an optical signal, it is apparent that the invention is not limited specifically thereto and is also applicable to an electrical signal.

As described above, according to the present invention, in a receiving device of the type that the receiving circuit output is applied as a trigger signal to a monostable multivibrator to generate pulses of a fixed width, the overall delay time $\tau$ of the received signal can be reduced by additional provision of the OR gate 18.

## Claims

1.   A digital signal receiving device comprising:

receiving circuit means which receives and detects an optical or electrical signal;

monostable multivibrator means which is triggered by the leading edge of a rectangular wave from said receiving circuit means and outputs a rectangular wave of a predetermined time width; and

OR gate means which outputs, as the output of said receiving device, the logical OR between the output from said monostable multivibrator means and the output from said receiving circuit means.

# FIG. 1A

MODULATOR        DRIVE CIRCUIT
11              12
                        13

$Sdi$        $Sm$

$Sop$  OPTICAL
       SIGNAL

T  TRANSMITTER

# FIG. 1B

RECEIVING R
CIRCUIT        AMPLIFIER   COMPARATOR   MULTI-
                                        VIBRATOR
                15          16          17          $Sdo$

14                              $Sd$        MM

$Sop$

# FIG. 2

INPUT SIGNAL TO TRANSMITTER

A    Sdi

MODULATED SIGNAL Sm OR OPTICAL SIGNAL

B    Sm/Sop

OUTPUT FROM RECEIVING CIRCUIT

C    Sd

DEMODULATED SIGNAL

D    Sdo

EP 0 600 091 A1

FIG. 3

INPUT SIGNAL TO TRANSMITTER  Sdi

OPTICAL SIGNAL  Sop  $\tau_1$

OUTPUT FROM RECEIVING CIRCUIT  Sd  $\tau_2$

MULTIVIBRATOR OUTPUT  Sdo  $\tau_3$  $\tau$

FIG. 4

AMPLIFIER  COMPARATOR  MULTIVIBRATOR

15  16  17

Sop  14  Sd  MM  Sdo  18  So

R  RECEIVING CIRCUIT

FIG. 5

A  INPUT SIGNAL TO TRANSMITTER  Sdi  Tw

B  OPTICAL SIGNAL  Sop  $\tau_1$

C  OUTPUT FROM RECEIVING CIRCUIT  Sd  $\tau_2$

D  MULTIVIBRATOR OUTPUT  Sdo  $\tau_3$

E  OR GATE OUTPUT  So  $\tau_4$  Tw

5

# INTERNATIONAL SEARCH REPORT

| International application No. |
| --- |
| PCT/JP93/00682 |

## A. CLASSIFICATION OF SUBJECT MATTER

Int. Cl$^5$   H03K5/13, H04L25/02

According to International Patent Classification (IPC) or to both national classification and IPC

## B. FIELDS SEARCHED

Minimum documentation searched (classification system followed by classification symbols)

Int. Cl$^5$   H03K5/13, H04L25/02

Documentation searched other than minimum documentation to the extent that such documents are included in the fields searched

| | |
| --- | --- |
| Jitsuyo Shinan Koho | 1926 – 1993 |
| Kokai Jitsuyo Shinan Koho | 1971 – 1993 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| A | JP, B2, 62-14467 (Toshiba Corp.), April 2, 1987 (02. 04. 87), Fig. 3 (Family: none) | 1 |
| A | JP, B2, 3-22745 (Hitachi Cable, Ltd.), March 27, 1991 (27. 03. 91), Fig. 3 (Family: none) | 1 |
| A | Microfilm of the specification and drawings annexed to the written application of Japanese Utility Model Application No. 6514/1976 (Laid-Open No. 99750/1977), (Hitachi, Ltd.), July 28, 1977 (28. 07. 77), (Family: none) | 1 |

☒ Further documents are listed in the continuation of Box C.     ☐ See patent family annex.

| Date of the actual completion of the international search | Date of mailing of the international search report |
| --- | --- |
| August 10, 1993 (10. 08. 93) | August 31, 1993 (31. 08. 93) |

| Name and mailing address of the ISA/ | Authorized officer |
| --- | --- |
| Japanese Patent Office | |
| Facsimile No. | Telephone No. |

Form PCT/ISA/210 (second sheet) (July 1992)